(19) Europäisches Patentamt
European Patent Office
Office européen des brevets

(11) **EP 2 553 482 B1**

(12) **EUROPÄISCHE PATENTSCHRIFT**

(45) Veröffentlichungstag und Bekanntmachung des Hinweises auf die Patenterteilung:
**30.09.2015 Patentblatt 2015/40**

(21) Anmeldenummer: **11712519.5**

(22) Anmeldetag: **29.03.2011**

(51) Int Cl.:
*G01R 31/327* (2006.01)     *H02J 7/14* (2006.01)

(86) Internationale Anmeldenummer:
**PCT/EP2011/054860**

(87) Internationale Veröffentlichungsnummer:
**WO 2011/120989 (06.10.2011 Gazette 2011/40)**

(54) **BORDNETZ FÜR EIN FAHRZEUG UND STEUERVORRICHTUNG FÜR EIN BORDNETZ**

VEHICLE ELECTRICAL CIRCUIT AND CONTROL DEVICE FOR THIS CIRCUIT

CIRCUIT ÉLECTRIQUE DE VÉHICULE ET COMMANDE POUR CE CIRCUIT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.03.2010 DE 102010013456**

(43) Veröffentlichungstag der Anmeldung:
**06.02.2013 Patentblatt 2013/06**

(73) Patentinhaber: **Continental Automotive GmbH**
**30165 Hannover (DE)**

(72) Erfinder:
• **REICHOW, Dirk**
  **93173 Wenzenbach (DE)**
• **STECKERMEIER, Tobias**
  **93059 Regensburg (DE)**
• **GALLI, Tobias**
  **93426 Roding (DE)**

(56) Entgegenhaltungen:
**EP-A2- 1 443 340     EP-B1- 1 152 249**
**DE-A1- 10 163 222     DE-C2- 4 028 242**
**FR-A1- 2 629 957     US-A1- 2009 108 814**
**US-B1- 6 275 161**

**Beschreibung**

Die Erfindung betrifft ein Bordnetz bzw. Energiesystem eines Fahrzeugs, und eine Steuervorrichtung für ein Bordnetz. Ferner betrifft die Erfindung ein Fahrzeug, insb. ein Hybridelektrofahrzeug, mit einem oben genannten Bordnetz.

Bordnetze bzw. Energiesysteme heutiger Kraftfahrzeuge umfassen einen als Drehstrommaschine mit nachgeschalteter Gleichrichterschaltung ausgebildeten Generator als Energiewandler, eine Energiespeichereinheit, welche bspw. eine oder mehreren Batterien oder Doppelschichtkondensatoren umfasst und von dem Generator G mit Strom aufgeladen wird, sowie eine Gruppe von über das Bordnetz zu versorgenden Energieverbrauchern, welche zusammengefasst als Systemlast bezeichnet werden.

Die Systemlast wird von dem Generator als der ersten bzw. primären Energieversorgungseinheit und der Energiespeichereinheit als der zweiten bzw. sekundären Energieversorgungseinheit mit Strom versorgt.

Das Bordnetz kann stationäre wie auch dynamische Zustände einnehmen. In so einem stationären Zustand wird die Systemlast bzw. werden die Energieverbraucher weitgehend allein von dem Generator mit Strom versorgt. Dabei liefert der Generator Strom mit einem Gleichspannungsanteil und einem überlagerten Wechselspannungsanteil.

Werden Energieverbraucher mit einer hohen Energieaufnahme oder Energieverbraucher, deren Energieaufnahme stark schwankt, wie z. B. Elektromotor, in das Bordnetz eingeschaltet, so steigt der Energie-bzw. Strombedarf im Bordnetz in kurzer Zeit sprungartig. Dies führt zu Welligkeiten in der Bordnetzspannung und dazu, dass der Generator die Bordnetzspannung im Bordnetz allein nicht mehr stabil halten kann und die Bordnetzspannung zu fallen droht.

In diesem Fall wird die Energiespeichereinheit in das Bordnetz eingeschaltet. Die Energiespeichereinheit stützt dann das Bordnetz bei dynamischen Laständerungen und hält die Bordnetzspannung im Bordnetz auf den erforderlichen Spannungspegel aufrecht.

Hierzu weist das Bordnetz eine Steuervorrichtung auf, welche die elektrische Versorgung der Systemlast durch den Generator und die Energiespeichereinheit steuert. Die Steuervorrichtung weist einen steuerbaren Schalter auf, welcher bei Erkennen der sprungartigen Steigerung des Strombedarfs im Bordnetz von der Steuervorrichtung angesteuert geschlossen wird und so die Energiespeichereinheit mit der Systemlast im Bordnetz elektrisch verbindet.

Wird die Energiespeichereinheit mit der Systemlast elektrisch verbunden, und die Systemlast von dem Generator als erste und der Energiespeichereinheit als zweite Energieversorgungseinheit mit Strom versorgt, so befindet sich das Bordnetz in einem Systemzustand, welcher als Nominalzustand bezeichnet wird. In einem Nominalzustand muss sichergestellt werden, dass der Schalter geschlossen bleibt.

Um zu prüfen und sicherzustellen, dass das Bordnetz in einem Nominalzustand von dem Generator und der Energiespeichereinheit mit ausreichendem Strom versorgt wird und somit intakt bleibt, muss der Schaltzustand des Schalters geprüft werden.

Bei bekannten Bordnetzen wird der Schaltzustand des Schalters entweder durch das Messen der stromproportionalen Spannung über den Schalter, oder durch das Messen des Stromes am Schalter ermittelt. Die Druckschrift DE 40 28 242 C2 beschreibt ein Bordnetz gemäß dem Oberbegriff des Anspruchs 1.

Da die Spannung proportional zu dem Strom ist, kann im ersten Fall aus dem Spannungsmesswert von 0V abgeleitet werden, dass der Stromwert 0A ist.

Weist der gemessene oder ermittelte Strom am Schalter den Wert 0A auf, so kann man schlussfolgern, dass der Schalter geöffnet ist und die Energiespeichereinheit nicht dem Bordnetz angeschlossen ist.

Die oben genannten Methoden zur Ermittlung des Schaltzustandes des Schalters sind aber nicht zuverlässig. In beiden Fällen kann eine falsche Aussage über den tatsächlichen Schaltzustand des Schalters getroffen werden, da der Stromwert 0A bei geöffnetem Schalter auch möglich ist.

Ist der Schalter geöffnet oder nicht richtig geschlossen, so fließt kein Strom von der Energiespeichereinheit durch den Schalter und liegt auch keine Spannung am Schalter. Also sowohl der Strom als auch die Spannung am Schalter weist den Wert 0A bzw. 0V auf. Dies wird von der Steuervorrichtung fälschlicherweise als "fehlerfrei geschlossener Schalter" angenommen.

In manchen Nominalzuständen, wobei der Strom von dem Generator für einen bestimmten Zeitraum allein ausreicht, die Systemlast im Bordnetz zu versorgen, kann der Strom von der Energiespeichereinheit und somit auch der Strom am Schalter den Wert 0A nehmen. Dies führt ebenfalls zu einer fehlerhaften Aussage über den Schaltzustand des Schalters.

Mit den oben beschriebenen Diagnosemethoden lässt sich also der Zustand "fehlerfrei geschlossener Schalter" von dem Zustand "unbeabsichtigt geöffneter oder nicht richtig geschlossener Schalter" nicht unterscheiden.

Die Aufgabe der vorliegenden Erfindung liegt somit darin, das eingangs genannte Bordnetz und die eingangs genannte Steuervorrichtung so zu modifizieren, dass eine zuverlässige Diagnose zu dem Schaltzustand des Schalters möglich ist.

Diese Aufgabe wird durch die unabhängigen Ansprüche gelöst. Vorteilhafte Ausgestaltungen sind Gegenstand der Unteransprüche.

Gemäß einem ersten Aspekt der Erfindung ist ein Bordnetz für ein Fahrzeug geschaffen. Das Bordnetz weist einen ersten und einen zweiten Knotenpunkt, zwischen dem ersten und dem zweiten Knotenpunkt einen ersten, einen zweiten und einen dritten Strompfad, auf. Der zweite Knotenpunkt ist auf elektrisches Massepotential einer elektrischen Masse angelegt. Das Massepotential bzw. die elektrische Masse ist hier gleich der Karosserie des Fahrzeugs, welches bzw. welche mit "Klemme 31" bezeichnet wird. Im ersten Strompfad weist das Bordnetz eine Systemlast mit zumindest einem Energieverbraucher auf, der über das Bordnetz mit elektrischer Energie versorgt wird. Im zweiten Strompfad weist das Bordnetz eine erste, primäre Energieversorgungseinheit auf, welche dem Bordnetz, somit der Systemlast elektrischen Strom mit zumindest einem Wechselspannungsanteil bereitstellt. Im dritten Strompfad weist das Bordnetz eine zweite, sekundäre Energieversorgungseinheit zum Bereitstellen eines elektrischen Stromes, und einen steuerbaren Schalter auf. Der Schalter weist einen ersten, dem ersten Knotenpunkt zugewandten Anschluss, und einen zweiten, dem zweiten Knotenpunkt zugewandten Anschluss. "Zugewandt" heißt hier, dass der eine Anschluss dem einen Knotenpunkt gerichtet ist, d. h. im Vergleich zu dem anderen Anschluss dem einen Knotenpunkt schaltungstechnisch naher liegt. In einem geschlossenen Schaltzustand schließt der Schalter den ersten Anschluss mit dem zweiten Anschluss elektrisch kurz und stellt so einen geschlossenen Stromversorgungskreis von der zweiten Energieversorgungseinheit zu der Systemlast her. In einem geöffneten Schaltzustand öffnet der Schalter diesen Stromversorgungskreis wieder. Das Bordnetz umfasst ferner eine Vergleichseinrichtung zum Erfassen eines Spannungspotentials mit dem Wechselspannungsanteil der ersten Energieversorgungseinheit an einem Messpunkt zwischen dem ersten Anschluss des Schalters und dem ersten Knoten, insb. am ersten Anschluss des Schalters, und zum Vergleichen des gemessenen Spannungspotentials mit dem Wechselspannungsanteil mit einem ersten vorgegebenen Vergleichsspannungspotential. Außerdem umfasst das Bordnetz eine Erkennungseinrichtung zum Erkennen eines geöffneten Schaltzustands des Schalters abhängig von dem Vergleichsergebnis des Spannungspotentials mit dem ersten Vergleichsspannungspotential.

Entscheidend ist, dass dabei nicht die an dem Schalter anliegende Spannung, also die Spannung zwischen den beiden Anschlüssen des Schalters, sondern das Spannungspotential nur an dem nicht an der elektrischen Masse des Bordnetzes angeschlossenen bzw. nicht dieser elektrischen Masse zugewandten Anschluss des Schalters erfasst wird. Durch Abgreifen des Spannungspotentials an diesem Anschluss des Schalters kann in erster Linie der Wechselspannungsanteil im Bordnetz am ersten Anschluss erfasst werden. Anhand dieses Wechselspannungsanteils lässt sich dann der Schaltzustand bzw. die Funktionalität des Schalters fehlerfrei diagnostizieren.

Bei fehlerfrei geschlossenem Schalter sind die statischen und dynamischen Anteile, also der Gleichanteil und der Wechselanteil der Spannung der ersten Energieversorgungseinheit in Summe gleich groß wie die Spannung der zweiten Energieversorgungseinheit. Dabei nimmt das Spannungspotential am ersten Anschluss des Schalters einen bestimmten, außer einer vernachlässigbaren Abweichung weitgehend gleichbleibenden Wert. Dieser Wert kann vorab gemessen und als Vergleichsspannungspotential für späteren Vergleich mit späteren Messwerten abgespeichert werden. Alternativ kann das Vergleichsspannungspotential auch an einem geeigneten Punkt am Bordnetz z. B. am elektrischen Masseanschluss bei jedem Vergleichsvorgang erfasst werden.

Bei unbeabsichtigt geöffnetem oder fehlerhaft hochimpedantem Schalter schlägt der Wechselspannungsanteil auf dem ersten Anschluss des Schalters auf, sodass das an diesem Anschluss gemessene Spannungspotential von dem Vergleichsspannungspotential, welches bei einem fehlerfreien Schalter an diesem ersten Anschluss gemessen wurde, um den oben genannten Wechselspannungsanteil abweicht. Diese Potentialabweichung um diesen Wechselspannungsanteil wird von der Vergleichseinrichtung durch Vergleichen des aktuell am ersten Anschluss des Schalters gemessenen Spannungspotentials mit dem vorab gemessenen bzw. vorgegebenen Vergleichsspannungspotential erfasst.

Wird eine derartige Abweichung erfasst, so erkennt die Erkennungseinrichtung dann einen geöffneten Schaltzustand des Schalters. Durch Vergleich mit dem Sollschaltzustand des Schalters erkenn die Erkennungseinrichtung dann einen fehlerhaft geöffneten Schaltzustand des Schalters bzw. eine fehlerhafte Hochimpedanz bei dem Schalter.

Das Bordnetz weist in einer vorteilhaften Ausgestaltung eine Steuereinrichtung zum Schließen/Öffnen des Schalters und zur Ausgabe eines Sollschaltzustandssignals an die Erkennungseinrichtung auf, wobei das Sollschaltzustandssignal den aktuellen Sollschaltzustand des Schalters wiedergibt. Die Erkennungseinrichtung erkennt dann einen fehlerhaft geöffneten Schaltzustand bzw. einen fehlerhaft hochimpedanten Zustand des Schalters abhängig von dem Vergleichsergebnis des Spannungspotentials mit dem ersten Vergleichsspannungspotential und abhängig von dem Sollschaltzustandssignal der Steuereinrichtung.

Dadurch können die Zustände, in denen der Schalter beabsichtigt und fehlerfrei geöffnet ist, von den Schaltzuständen, in denen der Schalter unbeabsichtigt und fehlerhaft geöffnet oder hochimpedant ist, problemlos unterschieden werden. Folglich kann eine leistungslose Leitfähigkeitsdiagnose von einem elektronischen oder elektromechanischen Schalter in einem Bordnetz fehlerfrei durchgeführt werden.

In einer weiteren vorteilhaften Ausgestaltung weist die Vergleichseinrichtung eine erste Komparatoreinheit sowie eine erste Hüllkurvendetektionseinheit (in Englisch: Peak Envelope Detector) auf. Die Komparatoreinheit hat einen nichtinvertierenden Signaleingang und einen invertierenden Signaleingang. Die Komparatoreinheit dient dazu, das am positiven.Signaleingang anliegende, am ersten Anschluss des Schalters erfasst und von der zwischengeschalteten ersten Hüllkurvendetektionseinheit umgewandelte Spannungspotential mit dem am negativen Signaleingang anliegenden, ersten Vergleichsspannungspotential zu vergleichen und das Vergleichsergebnis in Form von einem ersten Ausgangssignal an die Erkennungseinrichtung weiterzuleiten. Die erste Hüllkurvendetektionseinheit ist zwischen dem ersten Anschluss des Schalters und dem positiven Signaleingang der ersten Komparatoreinheit zwischengeschaltet und dient dazu, aus dem am ersten Anschluss des Schalters erfassten durchaus wellenförmigen Wechselspannungsanteil eine Gleichspannung zu gewinnen, welche aus den positiven Maximalwerten des Wechselspannungsanteils besteht. Vorzugsweise umfasst die Hüllkurvendetektionseinheit einen Gleichrichter aus einer Diode, der nur die positiven Spannungspotentiale vom Wechselspannungsanteil durchlässt, und einen nachgeschalteten Tiefpassfilter aus einem Wiederstand und einem Kondensator zur Bildung der Gleichspannung aus den Maximalwerten des Wechselspannungsanteils.

In einer vorteilhaften Ausgestaltung ist der negative Signaleingang der ersten Komparatoreinheit mit einer elektrischen Masse, also mit einem Massepotential elektrisch verbunden ist. In diesem Fall ist das erste Vergleichsspannungspotential ein Massepotential an der elektrischen Masse.

Mit der ersten Hüllkurvendetektionseinheit kann aus dem wellenförmigen Wechselspannungsanteil, welcher bedingt durch den Systemzustand und die Systemtopologie auch negative Spannungswerte annehmen kann, eine Gleichspannung erzeugt werden, welche dann später von der Komparatoreinheit mit dem Vergleichsspannungspotential einfach verglichen werden kann.

In einer weiteren vorteilhaften Ausgestaltung weist die Vergleichseinrichtung eine zweite Komparatoreinheit, eine zweite Hüllkurvendetektionseinheit sowie einen Inverter auf. Der Inverter und die zweite Hüllkurvendetektionseinheit sind zwischen dem positiven Signaleingang der zweiten Komparatoreinheit und dem ersten Anschluss des Schalters zwischengeschaltet. Die zweite Komparatoreinheit mit einem nichtinvertierenden Signaleingang und einem invertierenden Signaleingang dient dazu, das am positiven Signaleingang anliegende, am ersten Anschluss des Schalters erfasst, von dem zwischengeschalteten Inverter invertiert und von der zwischengeschalteten zweiten Hüllkurvendetektionseinheit umgewandelte Spannungspotential mit einem am negativen Signaleingang anliegenden, zweiten Vergleichsspannungspotential zu vergleichen und das Vergleichsergebnis in Form von einem zweiten Ausgangssignal an die Erkennungseinrichtung weiterzuleiten.

Wie die erste Hüllkurvendetektionseinheit umfasst die zweite Hüllkurvendetektionseinheit vorzugsweise einen Gleichrichter aus einer Diode, der nur die positiven Spannungspotentiale durchlässt, und einen nachgeschalteten Tiefpassfilter aus einem Wiederstand und einem Kondensator. Die zweite Hüllkurvendetektionseinheit ist zwischen dem ersten Anschluss des Schalters und dem positiven Signaleingang der zweiten Komparatoreinheit zwischengeschaltet und dient ähnlich wie die erste Hüllkurvendetektionseinheit dazu, aus dem am ersten Anschluss des Schalters erfassten durchaus wellenförmigen Wechselspannungsanteil eine Gleichspannung zu gewinnen. Anders als bei der ersten Hüllkurvendetektionseinheit wird der am ersten Anschluss des Schalters erfassten Wechselspannungsanteil zuerst von dem zwischen dem Eingang der zweiten Hüllkurvendetektionseinheit und dem ersten Anschluss des Schalters zwischengeschalteten Inverter invertiert, sodass die Gleichspannung am Ausgang der zweiten Hüllkurvendetektionseinheit aus den negativen Maximalwerten des Wechselspannungsanteils besteht. Mit anderen Worten: der am ersten Anschluss des Schalters erfasste Wechselspannungsanteil wird zuerst von dem Inverter invertiert an die nachgeschaltete zweite Hüllkurvendetektionseinheit weitergleitet. Da die zweite Hüllkurvendetektionseinheit wie die erste Hüllkurvendetektionseinheit von der Eingangsspannung nur die positiven Maximalwerte passieren lässt und anschließend aus diesen positiven Maximalwerten eine Tiefpass gefilterte Gleichspannung erzeugt, werden hier nur die durch den Inverter invertierten negativen Maximalwerte des Wechselspannungsanteils von der zweiten Hüllkurvendetektionseinheit zu einer Gleichspannung gebildet. Anhand des zweiten Ausgangsignals der Vergleichseinrichtung erkennt dann die Erkennungseinrichtung Flussrichtung eines durch den geschlossenen Schalter fließenden Stromes.

Vorzugsweise ist der negative Signaleingang der zweiten Komparatoreinheit mit der elektrischen Masse elektrisch verbunden. In diesem Fall ist das zweite Vergleichsspannungspotential ein Massepotential an der elektrischen Masse.

Alternativ ist das zweite Vergleichsspannungspotential das Ausgangssignal der ersten Hüllkurvendetektionseinheit und die zweite Komparatoreinheit vergleicht in diesem Fall die Ausgangssignale der ersten und der zweiten Hüllkurvendetektionseinheit zueinander.

Gemäß einem zweiten Aspekt der Erfindung ist eine Steuervorrichtung zum Steuern eines Stromflusses in einem Bordnetz mit einem Wechselspannungsanteil geschaffen.

Die erfindungsgemäße Steuervorrichtung weist einen ersten, positiven, nicht an einer elektrischen Masse mit einem Massepotential anzuschließenden, Verbindungsanschluss, einen zweiten, negativen, an einer elektrischen Masse anzuschießenden Verbindungsanschluss, einen steuerbaren Schalter mit einem ersten Anschluss zum ersten Verbindungsanschluss der Steuervorrichtung und einem zweiten Anschluss zum zweiten Verbindungsanschluss der Steuervorrichtung, wobei der Schalter in einem geschlossenen Schaltzustand den ersten Verbindungsanschluss der Steuervorrichtung mit dem zweiten Verbindungsanschluss der Steuervorrichtung elektrisch verbindet.

Ferner umfasst die Steuervorrichtung eine Vergleichseinrichtung zum Erfassten des Wechselspannungsanteils am Bordnetz über den ersten Verbindungsanschluss und zum Vergleichen des erfassten Wechselspannungsanteils mit einem vorgegebenen Vergleichsspannungspotential, sowie eine Erkennungseinrichtung zum Erkennen eines Schaltzustands des Schalters abhängig von dem Vergleichergebnis des Wechselspannungsanteils mit dem vorgegebenen Vergleichsspannungspotential.

In einer vorteilhaften Ausgestaltung weist die Steuervorrichtung zudem eine Steuereinrichtung zum gesteuerten Schließen/Öffnen des Schalters und zur Ausgabe eines Sollschaltzustandssignals an die Erkennungseinrichtung auf, wobei das Sollschaltzustandssignal den aktuellen Sollschaltzustand des Schalters wiedergibt.

Die Erkennungseinrichtung erkennt dann einen fehlerhaft geöffneten Schaltzustand des Schalters oder einen fehlerhaften Schalter durch Vergleichen des Vergleichsergebnisses der Vergleicheinrichtung mit dem Sollschaltzustandssignal der Steuereinrichtung.

Vorteilhafterweise weist die Vergleicheinrichtung eine erste Komparatoreinheit mit einem nichtinvertierenden Signaleingang und einem invertierenden Signaleingang sowie eine erste Hüllkurvendetektionseinheit zwischen dem ersten Verbindungsanschluss der Steuervorrichtung und dem positiven Signaleingang der ersten Komparatoreinheit auf.

Der negative Signaleingang der ersten Komparatoreinheit ist vorzugsweise mit dem zweiten Verbindungsanschluss elektrisch verbunden. In diesem Fall ist das erste Vergleichsspannungspotential ein an dem zweiten Verbindungsanschluss anliegendes Spannungspotential.

In einer weiteren vorteilhaften Ausgestaltung weist die Steuervorrichtung eine zweite Komparatoreinheit mit einem nichtinvertierenden Signaleingang und einem invertierenden Signaleingang zum Vergleichen des am ersten Verbindungsanschluss der Steuervorrichtung anliegenden Spannungspotentials mit einem zweiten vorgegebenen Vergleichsspannungspotential vergleicht und zur Weitergabe dieses Vergleichsergebnisses an die Erkennungseinrichtung.

Die Erkennungseinrichtung erkennt dann anhand des zweiten Vergleichsergebnisses der Vergleicheinrichtung Flussrichtung eines durch den Schalter fließenden Stromes.

Vorteilhafterweise weist die Steuervorrichtung hierzu eine zweite Hüllkurvendetektionseinheit zwischen dem ersten Verbindungsanschluss der Steuervorrichtung und dem positiven Signaleingang der zweiten Komparatoreinheit und einen Inverter zwischen dem ersten Verbindungsanschluss der Steuervorrichtung und der zweiten Hüllkurvendetektionseinheit auf.

Dabei ist der negative Signaleingang der zweiten Komparatoreinheit mit dem zweiten Verbindungsanschluss elektrisch verbunden und das zweite Vergleichsspannungspotential ist das an dem zweiten Verbindungsanschluss anliegende Spannungspotential.

Alternativ ist einer der beiden Signaleingänge der zweiten Komparatoreinheit mit dem Ausgang ersten Hüllkurvendetektionseinheit elektrisch verbunden. In diesem Fall vergleicht die zweite Komparatoreinheit die Ausgangssignale der beiden Hüllkurvendetektionseinheiten zueinander.

Mit der oben beschriebenen Steuervorrichtung ist es möglich, den Einschaltwiderstand bzw. Durchgangswiderstand eines elektrischen Schalters innerhalb eines geschlossenen elektrischen Gesamtsystems bspw. eines Bordnetzes eines Fahrzeugs mit mindestens einem Bordnetz, in dem ein Strom mit einem Wechselspannungsanteil fließt, zu messen und anhand der gemessenen Daten die fehlerhaften Schaltzustände des Schalters oder die Funktionsstörung bei dem Schalter zu diagnostizieren.

Gemäß einem weiteren Aspekt der vorliegenden Erfindung wird ein Fahrzeug, insbesondere ein Kraftfahrzeug, mit einem Bordnetz, insb. einem Bordnetz, oder mit einer Steuervorrichtung wie oben beschrieben worden ist, geschaffen.

Vorteilhafte Ausgestaltungen des oben dargestellten Bordnetzes sind, soweit im Übrigen auf die Steuervorrichtung bzw. auf das Fahrzeug übertragbar, auch als vorteilhafte Ausgestaltungen der Steuervorrichtung beziehungsweise des Fahrzeugs anzusehen.

Im Folgenden sollen nun beispielhafte Ausführungsbeispiele der vorliegenden Erfindung Bezug nehmend auf die beiliegenden Zeichnungen näher erläutert werden. Als Ausführungsbeispiel dient ein Bordnetz eines Fahrzeugs. In den Figuren sind lediglich die Komponenten eines Bordnetzes darstellt, welche zur Beschreibung der Erfindung unerlässlich sind. Je nach Ausgestaltung kann das Bordnetz weitere Komponenten aufweisen, welche hier aber zur übersichtlichen Beschreibung der Erfindung nicht näher dargestellt werden. Es zeigen:

Fig. 1      eine vereinfachte schematische Darstellung eines Bordnetzs;

Fig. 2      eine schematische Darstellung eines Bordnetzs gemäß einem ersten Ausführungsbeispiel der Erfindung;

Figur 3      eine schematische Darstellung eines Bordnetzs gemäß einem zweiten Ausführungsbeispiel der Erfindung;

Figur 4a      eine Detailansicht der ersten Hüllkurvendetektionseinheit gemäß dem ersten Ausführungsbeispiel;

Figur 4b      eine Detailansicht der zweiten Hüllkurvendetektionseinheit gemäß dem zweiten Ausführungsbeispiel;

Figur 5a    eine schematische Darstellung der Signale der Komponenten des Bordnetzes gemäß dem ersten Ausführungsbeispiel;

Figur 5b    eine schematische Darstellung der Signale der Komponenten des Bordnetzes gemäß dem zweiten Ausführungsbeispiel.

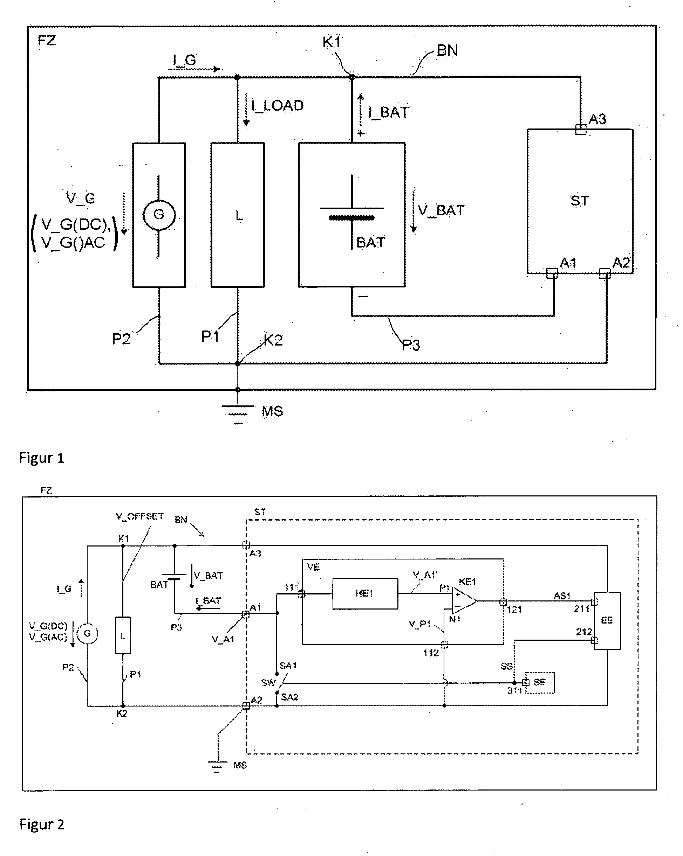

Das Bordnetz BN eines Fahrzeugs FZ umfasst gemäß Figur 1 einen Generator G, eine Batterie BAT, eine Gruppe von Energieverbrauchern, welche zusammenfasst Systemlast L bezeichnet werden, sowie eine Steuervorrichtung ST.

Der Generator G ist als Drehstrommaschine mit nachgeschalteter Gleichrichterschaltung ausgebildet und dient als primäre Energieversorgungseinheit im Bordnetz BN und versorgt die Systemlast L mit elektrischem Strom. Zudem hat der Generator G auch die Aufgabe, die Batterie BAT mit Strom bzw. elektrischer Energie aufzuladen. Der Generator G speist elektrischen Strom mit einem Gleichspannungsanteil V_G(DC) und einem Wechselspannungsanteil V_G(AC) in das Bordnetz BN.

Die Batterie BAT dient als sekundäre Energieversorgungseinheit im Bordnetz BN und kann die Systemlast L mit elektrischem Strom beliefern.

Die Steuervorrichtung ST steuert den Stromfluss von dem Generator G zur Systemlast L und zur Batterie BAT, bzw. von der Batterie BAT zur Systemlast L.

Über einen ersten Anschluss A1 ist die Steuervorrichtung ST mit dem Minuspol der Batterie BAT elektrisch verbunden. Über einen zweiten Anschluss A2 ist die Steuervorrichtung ST mit dem Minuspol des Generators G, der Systemlast L sowie der elektrischen Masse MS, also mit der Karosserie des Fahrzeugs FZ (Klemme 31), elektrisch verbunden.

Über einen dritten Anschluss A3 ist die Steuervorrichtung ST mit dem Pluspol des Generators G, der Systemlast L und dem Pluspol der Batterie BAT elektrisch verbunden. Über diesen dritten Anschluss A3 erhält die Steuervorrichtung ST Betriebsstrom.

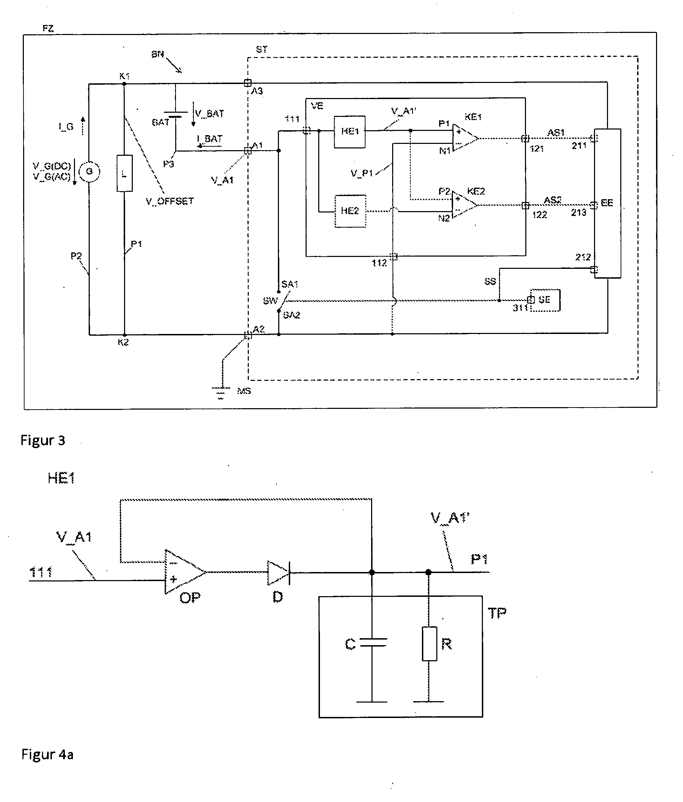

Nun sei auf Figuren 2, 4a verwiesen, in denen das Bordnetz gemäß dem ersten Ausführungsbeispiel der Erfindung schematisch dargestellt ist. Die Steuervorrichtung ST umfasst gemäß Figur 2 einen Schalter SW zwischen dem ersten A1 und zweiten A2 Anschluss, eine Steuereinrichtung SE zum gesteuerten Schließen/Öffnen des Schalters SW, eine Vergleichseinrichtung VE sowie eine Erkennungseinrichtung EE.

Die Steuereinrichtung SE weist einen Ausgang 311 auf. Mit einem Steuersignal SS am Ausgang 311 steuert die Steuereinrichtung SE den Schalter SW und gibt die Steuereinrichtung SE dieses Steuersignals als ein Sollschaltzustandssignal an die Erkennungseinrichtung EE aus, welches den aktuellen Sollschaltzustand des Schalters SW wiedergibt und einen Signalpegel von logisch NULL für den "geschlossenen Sollschaltzustand des Schalters SW" oder logisch EINS für den "geöffneten Sollschaltzustand des Schalters" annimmt.

Die Vergleichseinrichtung VE weist zwei Signaleingänge 111, 112 und einen Signalausgang 121 auf. Über den ersten Signaleingang 111 ist die Vergleichseinrichtung VE unmittelbar mit dem ersten Anschluss A1 der Steuervorrichtung ST elektrisch verbunden. Über diesen Eingang 111 erfasst die Vergleichseinrichtung VE das Spannungspotential V_A1 am ersten Anschluss A1 der Steuervorrichtung ST bzw. am ersten Anschluss SA1 des Schalters SW.

Über den zweiten Signaleingang 112 erhält die Vergleichseinrichtung VE das erste Vergleichsspannungspotential VP1, welches in diesem Ausführungsbeispiel das Massepotential am zweiten Anschluss A2 bzw. der Steuervorrichtung ST bzw. an elektrischer Masse MS des Bordnetzes BN, also an der Karosserie des Fahrzeugs FZ, darstellt.

Über den Signalausgang 121 gibt die Vergleichseinrichtung VE abhängig von dem Vergleichsergebnis zwischen dem Spannungspotential V_A1 und dem Vergleichsspannungspotential VP1 ein Ausgangssignal AS1 mit einem Signalpegel von logisch NULL oder logisch EINS an die Erkennungseinrichtung EE aus.

Dieses Ausgangssignal AS1 und das Sollschaltzustandssignal SS von der Steuereinrichtung SE erhält die Erkennungseinrichtung EE über deren zwei Signaleingänge 211, 212. Basierend auf diese beiden Signale AS1, SS erkennt die Erkennungseinrichtung EE dann, ob der Schalter SW ordnungsgemäß oder unkontrolliert bzw. fehlerhaft geöffnet (bzw. hochimpedant) ist.

Die Vergleichseinrichtung VE umfasst eine erste Hüllkurvendetektionseinheit HE1 und eine erste Komparatoreinheit KE1, wobei die erste Hüllkurvendetektionseinheit HE1 zwischen dem ersten Anschluss A1 der Steuervorrichtung ST und dem positiven Eingang P1 der ersten Komparatoreinheit KE1 zwischengeschaltet ist und das am ersten Anschluss A1 erfasste Spannungspotential V_A1 zu einem aus den detektierten Maximalwerten bestehenden Gleichspannungspotential V_A1' umgewandelt an den positiven Eingang P1 der ersten Komparatoreinheit KE1 weiterleitet.

Die Komparatoreinheit KE1 vergleicht das am positiven Eingang P1 anliegende, aus dem Spannungspotential V_A1 umgewandelte Gleichspannungspotential V_A1' mit dem am negativen Eingang N1 anliegenden ersten Vergleichsspannungspotential VP1.

Überschreitet das Gleichspannungspotential V_A1' das erste Vergleichsspannungspotential VP1, so setzt die Komparatoreinheit KE1 das Ausgangssignal AS1 der Vergleichseinrichtung VE auf einen Signalpegel von logisch EINS und gibt dieses Signal AS1 mit einem Signalpegel von logisch EINS an die Erkennungseinrichtung EE aus.

Ist das Gleichspannungspotential V_A1' (abgesehen von einer vernachlässigbaren Abweichung) gleich groß wie das erste Vergleichsspannungspotential VP1, so setzt die erste Komparatoreinheit KE1 das Ausgangssignal AS1 auf einen Signalpegel von logisch NULL.

Erhält die Erkennungseinrichtung EE sowohl das Sollschaltzustandssignal SS von der Steuereinrichtung SE als auch das erste Ausgangssignal AS1 von der Vergleichseinrichtung VE mit einem Signalpegel von logisch EINS, so erkennt diese, dass der Schalter SW gesteuert geöffnet wurde und sich fehlerfrei in diesem geöffneten Schaltzustand befindet.

Erhält die Erkennungseinrichtung EE beide Signale SS, AS1 mit einem Signalpegel von logisch NULL, so erkennt diese, dass der Schalter SW gesteuert geschlossen wurde und sich fehlerfrei in diesem geschlossenen Schaltzustand befindet.

Erhält die Erkennungseinrichtung EE jedoch das Sollschaltzustandssignal SS mit einem Signalpegel von logisch NULL aber das Ausgangssignal AS1 mit einem Signalpegel von logisch EINS, so erkennt diese, dass der Schalter SW unkontrolliert also fehlerhaft geöffnet bzw. sich in einem fehlerhaft geöffneten Schaltzustand befindet oder fehlerhaft hochimpedant ist.

Die Steuereinrichtung SE, die Erkennungseinrichtung EE bzw. die Vergleichseinrichtung VE können bspw. in einem Mikrokontroller implementiert sein und werden von dem Generator G oder von der Batterie BAT über den dritten Anschluss A3 der Steuervorrichtung ST mit Strom versorgt.

Gemäß Figur 4a, in die Detailansicht der Hüllkurvendetektionseinheit HE1 des ersten Ausführungsbeispiels schematisch dargestellt ist, weist die Hüllkurvendetektionseinheit HE1 einen aus einem Kondensator C und einem Widerstand R bestehenden Tiefpassfilter TP und eine Diode D als Gleichrichter. Die Kathode der Diode D ist mit dem Tiefpassfilter TP und dem Eingang P1 der ersten Komparatoreinheit KE1 verbunden. Die Diode D leitet nur die positiven Anteile des am Eingang 111 der Vergleichsvorrichtung VE anliegenden Spannungspotentials V_A1 an den Tiefpassfilter weiter und sperrt die negativen Anteile.

Zwischen dem Eingang 111 und der Anode der Diode D ist ein Spannungsfolger (Impedanzwandler) in Form eines rückgekoppelten Operationsverstärkers OP angeordnet, wobei der Rückkopplungspfad des Spannungsfolgers zwischen der Kathode der Diode bzw. dem Tiefpassfilter TP und dem inventierenden Eingang des Operationsverstärkers OP angeordnet ist.

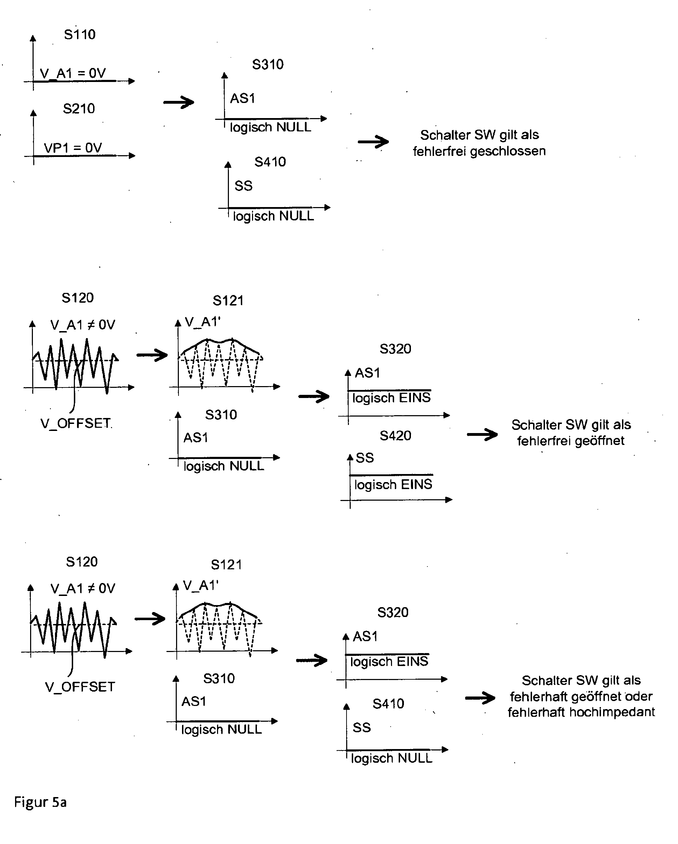

Die Funktionsweise der in diesem ersten Ausführungsbeispiel gemäß Figuren 2, 4a gezeigten Steuervorrichtung ST wird nachfolgend basierend auf Signaldiagramme in Figur 5a näher beschrieben.

Der Generator G speist einen Strom mit einem Gleichspannungsanteil V_G(DC) und einem Wechselspannungsanteil V_G(AC) in das Bordnetz BN. Bei geschlossenem Schalter SW speist die Batterie BAT zusätzlich einen Strom mit nur einem Gleichspannungsanteil V_BAT in das Bordnetz (streng genommen mit der Zeit langsam abfallende Spannung, jedoch keine Wechselspannung, deren Polarität regelmäßig wechselt).

Bei fehlerfrei geschlossenem Schalter SW erfüllen die Gleich- und Wechselspannungsanteile der Generatorspannung V_G(DC), V_G(AC) und die Batteriespannung V_BAT folgenden Zusammenhang:

$$V\_A1 = V\_G(DC) + V\_G(AC) - V\_BAT = 0V.$$

Am ersten Anschluss SA1 des Schalters SW bzw. am Verbindungsanschluss A1 der Steuervorrichtung ST wird so ein Spannungspotential V_A1 von 0V bzw. mit einer vernachlässigbären Abweichung nahezu 0V gemessen (Signal S110 in Figur 5a).

Dieses Spannungspotential V_A1 wird mit dem Vergleichsspannungspotential VP1 (Signal S210), welches hier ein Massepotential und somit ebenfalls 0V ist, von der ersten Komparatoreinheit KE1 der Vergleichseinrichtung VE verglichen.

Da diese beiden Potentiale V_A1, VP1 (mit einer vernachlässigbaren Abweichung) gleich groß sind, gibt die Vergleichseinrichtung VE ein Ausgangssignal AS1 mit einem Signalpegel von logisch NULL aus (Signal S310).

Hat das Sollschaltzustandssignal SS von der Steuereinrichtung SE einen Pegelwert von logisch NULL (Signal S410) und deutet somit auf einen geschlossenen Schalter SW hin, so gilt der Schalter SW als fehlerfrei geschlossen.

Ist der Schalter SW von der Steuereinrichtung SE gesteuert geöffnet bzw. in einem geöffneten Schaltzustand gehalten, oder ist der Schalter unkontrolliert geöffnet bzw. fehlerhaft hochimpedant, so wird am ersten Verbindungsanschluss A1 ein Spannungspotential V_A1 gemessen, welches eine Summe des Wechselanteils der Generatorspannung V_G(AC) und einer systembedingten Offset-Abweichung V_OFFSET und somit ungleich 0V ist (Signal S120):

$$V\_A1 = V\_G(DC) + V\_G(AC) - V\_BAT = V\_G(AC) \pm V\_OFFSET \neq 0V.$$

Dieses durch den Wechselspannungsanteil V_G(AC) dynamische Spannung V_A1 wird von der Hüllkurvendetektionseinheit HE1 zu einer statischen Spannung V_A1' umgewandelt (Signal S121), wobei nur die Maximalwerte der positiven Spannungsanteile selektiert und anschließend Tiefpass gefiltert zu dieser statischen Spannung V_A1' gebildet wurden. Diese Spannung V_A1' wird von der Komparatoreinheit KE1 mit dem Vergleichsspannungspotential VP1 (Signal S210) verglichen. Da diese Spannung V_A' größer als 0V und somit größer ist als das Vergleichsspannungspotential VP1 ist, gibt die Vergleichseinrichtung VE ein Ausgangssignal AS1 mit einem Signalpegel von logisch EINS (Signal S320) aus.

Hat das Sollschaltzustandssignal SS einen Pegelwert von logisch EINS (Signal S420) und deutet somit auf einen kontrolliert geöffneten Schalter SW hin, so gilt der Schalter SW als fehlerfrei geöffnet.

Hat das Sollschaltzustandssignal SS jedoch einen Pegelwert von logisch NULL (Signal S410) und deutet somit auf einen geschlossenen Sollschaltzustand des Schalters SW hin, so gilt der Schalter SW als unkontrolliert geöffnet bzw. fehlerhaft hochimpedant.

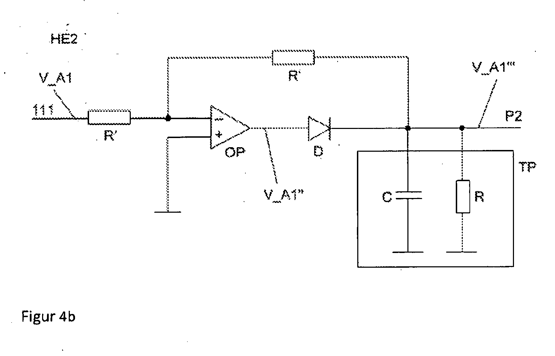

Nachdem das Bordnetz gemäß dem ersten Ausführungsbeispiel beschrieben wurde, wird nun das Bordnetz gemäß einem in Figuren 3, 4b dargestellten, zweiten Ausführungsbeispiel näher beschrieben. Die Steuervorrichtung ST dieses Bordnetzes BN weist im Vergleich zu der im ersten Ausführungsbeispiel gezeigten Steuervorrichtung ST neben der ersten Hüllkurvendetektionseinheit HE1 und der ersten Komparatoreinheit KE1 eine zweite Hüllkurvendetektionseinheit HE2 und eine zweite Komparatoreinheit KE2 in der Vergleichseinrichtung VE auf.

Die Vergleichseinrichtung VE weist einen weiteren Signalausgang 122 für ein zweites Ausgangssignal AS2 auf. Entsprechend weist die Erkennungseinrichtung EE einen dritten Signaleingang 213 für das zweite Ausgangssignal AS2 der Vergleichseinrichtung VE auf.

Mit dieser zweiten Hüllkurvendetektionseinheit HE2 und der zweiten Komparatoreinheit KE2 erkennt die Steuervorrichtung ST Flussrichtung des durch den Strompfad vom ersten Verbindungsanschluss A1 zum zweiten Verbindungsanschluss A2 bzw. durch den Schalter SW fließenden Stromes, welcher zugleich der Batteriestrom I_BAT der Batterie BAT ist. Damit erkennt die Steuervorrichtung ST einen Lade- bzw. Entladevorgang bei der Batterie BAT.

Der nichtinvertierende Eingang P2 der zweiten Komparatoreinheit KE2 ist mit dem Ausgang der ersten Hüllkurvendetektionseinheit HE1 verbunden. Der invertierende Eingang N2 der Komparatoreinheit KE2 ist mit dem Ausgang der zweiten Hüllkurvendetektionseinheit HE2 verbunden. Die zweite Komparatoreinheit KE2 vergleicht somit die Ausgangssignale der beiden Hüllkurvendetektionseinheiten HE1, HE2.

Anders als die erste Hüllkurvendetektionseinheit HE1 weist die zweite Hüllkurvendetektionseinheit HE2 gemäß Figur 4b anstelle des Impedanzwandlers einen invertierenden Verstärker in Form von einem rückgekoppelten Operationsverstärker OP mit jeweils einem Widerstand R' am Rückkopplungspfad sowie zwischen dem Eingang 111 und dem invertierenden Eingang des Operationsverstärkers OP auf. Dieser invertierende Verstärker dient zugleich als Inverter und als Spannungsfolger.

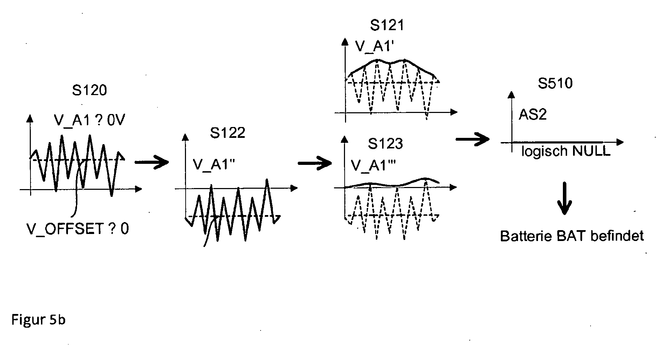

Die Funktionsweise der in diesem zweiten Ausführungsbeispiel gemäß Figuren 3, 4b gezeigten Steuervorrichtung ST wird nachfolgend basierend auf Figur 5b näher beschrieben.

Die oben genannte systembedingte Offset-Abweichung V_OFFSET ergibt sich durch folgende Gleichung:

$$V\_OFFSET = V\_G(DC) - V\_BAT.$$

Befindet sich die Batterie BAT in einem Ladevorgang, so gilt der Gleichspannungsanteil V_G(DC) des Generators G höher als die Batteriespannung V_BAT, da diese von dem Generator G aufgeladen wird. Folglich ist der V_OFFSET größer als 0V.

In einem Entladevorgang der Batterie BAT, während die Batterie BAT Strom ins Bordnetz BN einspeist, gilt der Gleichspannungsanteil V_G(DC) des Generators G nicht höher als die Batteriespannung V_BAT. Folglich ist der V_OFFSET gleich oder kleiner 0V.

Zur Erkennung der Stromflussrichtung im Strompfad zwischen dem Minuspol der Batterie BAT und der elektrischen Masse MS also der Karosserie des Fahrzeugs FZ, wird vorausgesetzt, dass in diesem Strompfad zumindest ein elektrisches bzw. elektronisches Bauelement zwischengeschaltet ist, das als ohm'scher Widerstand wirkt, also bei geschlossenem Schalter SW auf dieses Bauelement eine messbare Spannung anfällt.

Ferner wird angenommen, dass der Schalter SW kontrolliert und fehlerfrei geschlossen ist, und durch den Schalter SW ein messbarer Strom I_BAT hindurchfließt.

Das Spannungspotential V_A1, das am ersten Anschluss A1 gemessen wurde, wird von der zweiten Hüllkurvendetektionseinheit HE2 mit einem integrierten Inverter zuerst invertiert V_A1" (Signal S122) und zu einem invertierten Gleichspannungssignal V_A1''' (Signal S123) umgewandelt. Dieses Gleichspannungssignal V_A1''' (Signal S123) wird nun von der zweiten Komparatoreinheit KE2 mit dem Ausgangssignal V_A1' (Signal S121) der ersten Hüllkurvendetektionseinheit HE1 verglichen.

Ist der Signalpegel des Ausgangssignals V_A1' (Signal S121) der ersten Hüllkurvendetektionseinheit HE1 größer als der Pegel des Ausgangssignal V_A1''' (Signal S123) der zweiten Hüllkurvendetektionseinheit HE2, so gibt die zweite Komparatoreinheit KE2 ein Signal AS2 (Signal S510) mit logisch NULL. Erhält die Erkennungseinrichtung EE von der Vergleichseinrichtung VE das zweite Ausgangssignal AS2 (Signal S510) mit einem Signalpegel von logisch NULL, so erkennt diese, dass die Batterie BAT sich in einer Ladephase befindet, also von dem Generator G aufgeladen wird.

Sind die Ausgangssignale V_A1', V_A1''' der beiden Hüllkurvendetektionseinheiten HE1, HE2 (unter Berücksichtigung von einer vernachlässigbaren Abweichung) gleich groß, so gibt die zweite Komparatoreinheit KE2 ein Signal AS2 mit Signalpegel von logisch EINS auf. Erhält die Erkennungseinrichtung EE von der Vergleichseinrichtung VE das zweite Ausgangssignal AS2 mit einem Signalpegel von logisch EINS, so erkennt diese, dass die Batterie BAT sich in einer Endeladephase befindet, also das Bordnetz BN mit Strom versorgt.

Bezugszeichenliste

| | |
|---|---|
| FZ | Fahrzeug |
| BN | Bordnetz bzw. Bordnetz des Fahrzeugs FZ |
| L | Energieverbraucher im Bordnetz BN |
| G | erste Energieversorgungseinheit bspw. Generator |
| BAT | zweite Energieversorgungseinheit bspw. Batterie |
| ST | Steuervorrichtung |
| SW | steuerbarer Schalter |
| MS | elektrische Masse |
| SA1 | erster Anschluss des Schalters SW |
| SA2 | zweiter Anschluss des Schalters SW |
| VE | Vergleichseinrichtung |
| AS1 erstes | Ausgangssignal der Vergleichseinrichtung VE |
| AS2 | zweites Ausgangssignal der Vergleichseinrichtung VE |
| SE | Steuereinrichtung |
| SS | Sollschaltzustandssignal |
| EE | Erkennungseinrichtung |
| KE1 | erste Komparatoreinheit |
| P1 | nichtinvertierender Signaleingang der ernsten Komparatoreinheit KE1 |
| N1 | negativer invertierender Signaleingang der ersten Komparatoreinheit KE1 |
| HE1 | Hüllkurvendetektionseinheit |
| KE2 | zweite Komparatoreinheit |
| P2 | nichtinvertierender Signaleingang der zweiten Komparatoreinheit KE2 |
| N2 | invertierender Signaleingang der zweiten Komparatoreinheit KE2 |
| HE2 | zweiten Hüllkurvendetektionseinheit |
| A1 | erster Verbindungsanschluss der Steuervorrichtung ST |
| A2 | zweiter Verbindungsanschluss der Steuervorrichtung ST |
| A3 | dritter Verbindungsanschluss der Steuervorrichtung ST |
| V_A1 | Spannungspotential am ersten Verbindungsanschluss A1 |
| VP1 | erstes Vergleichsspannungspotential |
| VP2 | zweites Vergleichsspannungspotential |

**Patentansprüche**

1. Bordnetz (BN) für ein Fahrzeug (FZ), mit folgenden Merkmalen:

- einem ersten Knotenpunkt (K1),
- einem zweiten Knotenpunkt (K2), der auf elektrisches Massepotential angelegt ist,
- einem ersten (P1), einem zweiten (P2) und einem dritten (P3) Strompfad zwischen dem ersten (K1) und dem zweiten (K2) Knotenpunkt,
- zumindest einem Energieverbraucher (L) im ersten Strompfad (P1),
- einer ersten Energieversorgungseinheit (G) im zweiten Strompfad (P2) zum Bereitstellen eines elektrischen Stromes mit zumindest einem Wechselspannungsanteil (V_G(AC)) für den zumindest einen Energieverbraucher (L),

- im dritten Strompfad (P3) einer zweiten Energieversorgungseinheit (BAT) zum Bereitstellen eines elektrischen Stromes für den zumindest einen Energieverbraucher (L), sowie einem steuerbaren Schalter (SW) mit einem ersten, dem ersten Knotenpunkt (K1) zugewandten Anschluss (SA1) und einem zweiten, dem zweiten Knotenpunkt (K2) zugewandten Anschluss (SA2), wobei im geschlossenen Schaltzustand des Schalters (SW) der erste Anschluss (SA1) mit dem zweiten Anschluss (SA2) elektrisch kurzschließt und so einen geschlossenen Stromkreis von der zweiten Energieversorgungseinheit (BAT) zu dem zumindest einen Energieverbraucher (L) herstellt, **gekennzeichnet durch**

- eine Vergleichseinrichtung (VE) zum Erfassen eines Spannungspotentials (V_A1) mit dem Wechselspannungsanteil (V_G(AC)) an einem Messpunkt zwischen dem ersten Anschluss (SA1) des Schalters (SW) und dem ersten Knoten (K1), und zum Vergleichen des Spannungspotentials (V_A1) mit einem ersten vorgegebenen Vergleichsspannungspotential (VP1), das ein Massepotential an einer elektrischen Masse (MS) ist, und
- eine Erkennungseinrichtung (EE) zum Erkennen eines geöffneten Schaltzustands des Schalters (SW) abhängig von einem Vergleichsergebnis des Spannungspotentials (V_A1) mit dem ersten Vergleichsspannungspotential (VP1).

2. Bordnetz (BN) nach Anspruch 1, **gekennzeichnet durch** die Erkennungseinrichtung (EE) zum Erkennen eines fehlerhaft geöffneten Schaltzustands bzw. eines fehlerhaft hochimpedanten Zustands des Schalters (SW) abhängig von dem Vergleichsergebnis des Spannungspotentials (V_A1) mit dem ersten Vergleichsspannungspotential (VP1) und abhängig von dem Sollschaltzustand des Schalters (SW).

3. Bordnetz (BN) nach Anspruch 1 oder 2, **gekennzeichnet durch** die Vergleichseinrichtung (VE) mit

- einer ersten Komparatoreinheit (KE1) zum Vergleichen des Spannungspotentials (V_A1) mit dem ersten Vergleichsspannungspotential (VP1), und
- einer ersten Hüllkurvendetektionseinheit (HE1) zwischen dem Messpunkt, insb. dem ersten Anschluss (SA1) des Schalters (SW), und der ersten Komparatoreinheit (KE1).

4. Bordnetz (BN) nach Anspruch 2 oder 3, **gekennzeichnet durch**

- die Vergleichseinrichtung (VE) mit einer zweiten Komparatoreinheit (KE2) zum Vergleichen des Spannungspotentials (V_A1) mit einem zweiten Vergleichsspannungspotential (VP2), und
- die Erkennungseinrichtung (EE) zum Erkennen eines Lade-/Entladevorgangs der zweiten Energieversorgungseinheit (BAT) abhängig von dem Vergleichsergebnis des Spannungspotentials (V_A1) mit dem zweiten Vergleichsspannungspotential (VP2),
- wobei die sekundäre Energieversorgungseinheit (BAT) ein wiederaufladbarer Speicher für elektrische Energie ist.

5. Bordnetz (BN) nach Anspruch 4, **gekennzeichnet durch** die Vergleichseinrichtung (VE) mit

- einem Inverter (IN) und einer zweiten Hüllkurvendetektionseinheit (HE2) zwischen dem Messpunkt, insb. dem ersten Anschluss (SA1) des Schalters (SW), und der zweiten Komparatoreinheit (KE2),
- wobei der Inverter (IN) das Spannungspotentials (V_A1) invertiert an die zweite Hüllkurvendetektionseinheit (HE2) weiterleitet.

6. Steuervorrichtung (ST) zum Steuern eines Stromflusses in einem Bordnetz (BN) eines Fahrzeugs (FZ) mit zumindest einem Wechselspannungsanteil (V_G(AC)), mit folgenden Merkmalen:

- einem ersten (A1) und einem zweiten (A2) Verbindungsanschluss zur Herstellung elektrischer Verbindungen von der Steuervorrichtung (ST) zum Bordnetz (BN),
- einem steuerbaren Schalter (SW) zwischen dem ersten (A1) und dem zweiten (A2) Verbindungsanschluss, wobei der Schalter (SW) in einem geschlossenen Schaltzustand den ersten Verbindungsanschluss (A1) mit dem zweiten Verbindungsanschluss (A2) elektrisch verbindet,
- einer Vergleichseinrichtung (VE) zum Erfassen des Wechselspannungsanteils (V_G(AC)) am Bordnetz (BN) und zum Vergleichen des erfassten Wechselspannungsanteils (V_G(AC)) mit einem vorgegebenen Vergleichsspannungspotential (VP1), das ein Massepotential an einer elektrischen Masse (MS) ist,
- einer Erkennungseinrichtung (EE) zum Erkennen eines Schaltzustands des Schalters (SW) abhängig von dem Vergleichsergebnis des Wechselspannungsanteils (V_G(AC)) mit dem vorgegebenen Vergleichsspannungspotential (VP1).

**7.** Fahrzeug (FZ) mit einem Bordnetz (BN) nach einem der Ansprüche 1 bis 5.

**Claims**

**1.** Vehicle electrical system (BN) for a vehicle (FZ), having the following features:

- a first node (K1),
- a second node (K2), to which electrical ground potential is applied,
- a first (P1), a second (P2) and a third (P3) current path between the first (K1) and the second (K2) node,
- at least one energy consumer (L) in the first current path (P1),
- a first energy supply unit (G) in the second current path (P2) for supplying an electric current with at least one AC voltage component (V_G(AC)) for the at least one energy consumer (L),
- in the third current path (P3), a second energy supply unit (BAT) for supplying an electric current for the at least one energy consumer (L), and a controllable switch (SW) with a first terminal (SA1) near to the first node (K1) and a second terminal (SA2) near to the second node (K2), wherein, in the closed switch state of the switch (SW), the first terminal (SA1) electrically short-circuits with the second terminal (SA2) and thus produces a closed circuit from the second energy supply unit (BAT) to the at least one energy consumer (L), **characterized by**
- a comparison device (VE) for acquiring a voltage potential (V_A1) with the AC voltage component (V_G(AC)) at a measurement point between the first terminal (SA1) of the switch (SW) and the first node (K1), and for comparing the voltage potential (V_A1) with a first predefined comparison voltage potential (VP1) which is a ground potential of an electrical ground (MS), and
- a recognition device (EE) for recognizing an open switch state of the switch (SW) on the basis of a comparison result of the voltage potential (V_A1) and the first comparison voltage potential (VP1).

**2.** Vehicle electrical system (BN) according to Claim 1, **characterized by** the recognition device (EE) for recognizing an erroneously open switch state or an erroneously high-impedance state of the switch (SW) on the basis of the comparison result of the voltage potential (V_A1) and the first comparison voltage potential (VP1) and on the basis of the nominal switch state of the switch (SW).

**3.** Vehicle electrical system (BN) according to Claim 1 or 2, **characterized by** the comparison device (VE) with

- a first comparator unit (KE1) for comparing the voltage potential (V_A1) with the first comparison voltage potential (VP1), and
- a first envelope detection unit (HE1) between the measurement point, in particular the first terminal (SA1) of the switch (SW), and the first comparator unit (KE1).

**4.** Vehicle electrical system (BN) according to Claim 2 or 3, **characterized by**

- the comparison device (VE) with a second comparator unit (KE2) for comparing the voltage potential (V_A1) with a second comparison voltage potential (VP2), and
- the recognition device (EE) for recognizing a charging/discharging process of the second energy supply unit (BAT) on the basis of the comparison result of the voltage potential (V_A1) with the second comparison voltage potential (VP2),
- wherein the secondary energy supply unit (BAT) is a rechargeable electrical energy store.

**5.** Vehicle electrical system (BN) according to Claim 4, **characterized by** the comparison device (VE) with

- an inverter (IN) and a second envelope detection unit (HE2) between the measurement point, in particular the first terminal (SA1) of the switch (SW), and the second comparator unit (KE2),
- wherein the inverter (IN) forwards the voltage potential (V_A1) to the second envelope detection unit (HE2) in an inverted manner.

**6.** Control device (ST) for controlling a flow of current in a vehicle electrical system (BN) of a vehicle (FZ) with at least one AC voltage component (V_G(AC)), having the following features:

- a first (A1) and a second (A2) connecting terminal for producing electrical connections from the control device (ST) to the vehicle electrical system (BN),
- a controllable switch (SW) between the first (A1) and the second (A2) connecting terminal, wherein the switch (SW) electrically connects the first connecting terminal (A1) to the second connecting terminal (A2) in a closed switch state,
- a comparison device (VE) for acquiring the AC voltage component (V_G(AC)) at the vehicle electrical system (BN) and for comparing the acquired AC voltage component (V_G(AC)) with a predefined comparison voltage potential (VP1), which is a ground potential at an electrical ground (MS),
- a recognition device (EE) for recognizing a switch state of the switch (SW) on the basis of the comparison result of the AC voltage component (V_G(AC)) and the predefined comparison voltage potential (VP1).

7. Vehicle (FZ) with a vehicle electrical system (BN) according to any of Claims 1 to 5.

**Revendications**

1. Réseau embarqué (BN) pour un véhicule (FZ) avec les caractéristiques suivantes :

   - un premier point nodal (K1),
   - un deuxième point nodal (K2) connecté au potentiel de masse électrique,
   - un premier (P1), un deuxième (P2) et un troisième (P3) trajet de courant entre le premier (K1) et le deuxième (K2) point nodal,
   - au moins une charge (L) dans le premier trajet de courant (P1),
   - une première source d'énergie (G) dans le deuxième trajet de courant (P2) pour la mise à disposition d'un courant électrique avec au moins une part de tension alternative (V_G(AC)) pour l'au moins une charge (L),
   - dans le troisième trajet de courant (P3) une deuxième source d'énergie (BAT) pour la mise à disposition d'un courant électrique pour l'au moins une charge (L), ainsi qu'un commutateur contrôlable (SW) avec un premier raccordement (SA1) orienté vers le premier point nodal (K1) et un deuxième raccordement (SA2) orienté vers le deuxième point nodal (K2), le premier raccordement (SA1) se court-circuitant électriquement avec le deuxième raccordement (SA2) lorsque le commutateur (SW) est fermé, établissant ainsi un circuit fermé de le deuxième source d'énergie (BAT) à l'au moins une charge (L), **caractérisé par**
   - un dispositif de comparaison (VE) permettant de mesurer un potentiel électrique (V_A1) avec la part de tension alternative (V_G(AC)) au niveau d'un point de mesure entre le premier raccordement (SA1) du commutateur (SW) et le premier noeud (K1) et de comparer le potentiel électrique (V_A1) avec un premier potentiel électrique de comparaison (VP1) prédéterminé, qui est un potentiel de masse au niveau d'une masse électrique (MS) et
   - un dispositif de détection (EE) pour la détection d'un état de commutation ouvert du commutateur (SW) en fonction du résultat de la comparaison du potentiel électrique (V_A1) avec le premier potentiel électrique de comparaison (VP1).

2. Réseau embarqué (BN) selon la revendication 1, **caractérisé par** le dispositif de détection (EE) pour la détection d'un état de commutation ouvert erroné ou d'un état à haute impédance erroné du commutateur (SW) en fonction du résultat de comparaison du potentiel électrique (V_A1) avec le premier potentiel électrique de comparaison (VP1) et en fonction de l'état de commutation de consigne du commutateur (SW).

3. Réseau embarqué (BN) selon la revendication 1 ou 2, **caractérisé par** le dispositif de comparaison (VE) avec

   - une première unité de comparateur (KE1) permettant de comparer le potentiel électrique (V_A1) avec le premier potentiel électrique de comparaison (VP1) et
   - une première unité de détection de courbe enveloppe (HE1) entre le point de mesure, plus particulièrement le premier raccordement (SA1) du commutateur (SW), et la première unité de comparateur (KE1).

4. Réseau embarqué (BN) selon la revendication 2 ou 3, **caractérisé par**

   - le dispositif de comparaison (VE) avec une deuxième unité de comparateur (KE2) permettant de comparer le potentiel électrique (V_A1) avec un deuxième potentiel électrique de comparaison (VP2) et
   - le dispositif de détection (EE) pour la détection d'un processus de charge/décharge de la deuxième source d'énergie (BAT) en fonction du résultat de la comparaison du potentiel électrique (V_A1) avec le deuxième potentiel électrique de comparaison (VP2),

- la source d'énergie secondaire (BAT) étant un accumulateur rechargeable en énergie électrique.

5. Réseau embarqué (BN) selon la revendication 4, **caractérisé par** le dispositif de comparaison (VE) avec

    - un inverseur (IN) et une deuxième unité de détection de courbe enveloppe (HE2) entre le point de mesure, plus particulièrement le premier raccordement (SA1) du commutateur (SW) et la deuxième unité de comparateur (KE2),
    - l'inverseur (IN) transmettant le potentiel électrique (V_A1) inversé à l'unité de détection de courbe enveloppe (HE2).

6. Dispositif de commande (ST) pour le contrôle d'un flux de courant dans un réseau embarqué (BN) d'un véhicule (FZ) avec au moins une part de tension alternative (V_G(AC)), avec les caractéristiques suivantes :

    - un premier (A1) et un deuxième (A2) raccordements de liaison pour la réalisation de liaisons électriques entre le dispositif de commande (ST) et le réseau embarqué (BN),
    - un commutateur contrôlable (SW) entre le premier (A1) et le deuxième (A2) raccordements de liaison, le commutateur (SW) reliant électriquement, dans un état de commutation fermé, le premier raccordement de liaison (A1) avec le deuxième raccordement de liaison (A2),
    - un dispositif de comparaison (VE) permettant de mesurer la part de tension alternative (V_G(AC)) au niveau du réseau embarqué (BN) et de comparer la part de tension alternative mesurée (V_G(AC)) avec un potentiel électrique de comparaison (VP1), qui est un potentiel de masse au niveau d'une masse électrique (MS),
    - un dispositif de détection (EE) pour la détection d'un état de commutation de commutation du commutateur (SW) en fonction du résultat de la comparaison de la part de tension alternative (V_G(AC)) avec la part de tension de comparaison (VP1) prédéterminée.

7. Véhicule (FZ) avec un réseau embarqué (BN) selon l'une des revendications 1 à 5.

Figur 1

Figur 2

Figur 3

Figur 4a

Figur 4b

S110

V_A1 = 0V

S210

VP1 = 0V

→

S310

AS1

logisch NULL

S410

SS

logisch NULL

→ Schalter SW gilt als fehlerfrei geschlossen

S120

V_A1 ≠ 0V

V_OFFSET

S121

V_A1'

→

S310

AS1

logisch NULL

→

S320

AS1

logisch EINS

S420

SS

logisch EINS

→ Schalter SW gilt als fehlerfrei geöffnet

S120

V_A1 ≠ 0V

V_OFFSET

S121

V_A1'

→

S310

AS1

logisch NULL

→

S320

AS1

logisch EINS

S410

SS

logisch NULL

→ Schalter SW gilt als fehlerhaft geöffnet oder fehlerhaft hochimpedant

Figur 5a

Figur 5b

**EP 2 553 482 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4028242 C2